# EUROPEAN PATENT SPECIFICATION

(11) **EP 4 382 932 B1**
(45) Date of publication and mention of the grant of the patent: **11.11.2026**
(21) Application number: 22853339.4
(22) Date of filing: 27.07.2022
(51) Int. Cl.: G01R 31/367, G01R 31/28, G01R 31/36, G01R 31/371, H02J 7/00, G01R 31/385, H01M 10/44, H01M 10/48, H01M 10/42

(54) **BATTERY TESTING SYSTEM**
BATTERIETESTSYSTEM
SYSTÈME DE TEST DE BATTERIE

(30) Priority: 03.08.2021 KR 20210102178
(43) Date of publication of application: 12.06.2024
(73) Proprietor: LG ENERGY SOLUTION, LTD., Seoul 07335 (KR)
(72) Inventor: HWANG, Ji Won, Daejeon 34122 (KR); LEE, Sang Hoon, Daejeon 34122 (KR)
(74) Representative: Goddar, Heinz J.
(86) International application number: PCT/KR2022/011055
(87) International publication number: WO 2023/013961

(56) References cited:
- CN-A- 104 541 385
- CN-A- 113 125 977
- JP-A- H08 190 938
- KR-A- 20080 105 141
- KR-A- 20130 054 766
- KR-A- 20160 024 980
- KR-A- 20200 049 770
- KR-A- 20210 016 154
- US-A1- 2012 189 879
- US-A1- 2019 317 151
- US-A1- 2019 317 152

## Description

### [TECHNICAL FIELD]

### CROSS-REFERENCE TO RELATED APPLICATION

This application claims priority to and the benefit of Korean Patent Application No. 10-2021-0102178 filed in the Korean Intellectual Property Office on August 3, 2021.

### TECHNICAL FIELD

Embodiments disclosed herein relate to a battery testing apparatus and a battery testing system.

### [BACKGROUND ART]

An electric vehicle is supplied with electricity from outside to charge a battery cell, and then a motor is driven by a voltage charged in the battery cell to obtain power. Battery cells of electric vehicles repeatedly expand and contract due to chemical reactions that occur in a process of charging and discharging electricity, such that a risk of explosion may exist. Thus, the stability of a battery cell has to be verified through various tests in production.

Atypical battery cell testing system performs various tests while loading a battery cell on a tray and transporting the tray with specific equipment. However, since such a passive battery cell testing system tests a battery for a short test time while conveying a tray, there is a problem in that a defective battery cell leaks to an assembly process and a test for the battery is difficult to perform frequently. US 2019 / 317 152 A1 and US 2019 / 317 151 A1 respectively describe a real-time electrochemical impedance spectroscopy (EIS) apparatus, and CN 113 125 977 A describes a self-discharge screening method for a lithium ion battery. JP H08-190938 A describes a further battery testing apparatus.

### [DISCLOSURE]

### [TECHNICAL PROBLEM]

Embodiments disclosed herein aim to provide a battery testing apparatus and a battery testing system capable of performing accurate and continuous tests by automatically performing a battery cell test.

Technical problems of the embodiments disclosed herein are not limited to the above-described technical problems, and other unmentioned technical problems would be clearly understood by one of ordinary skill in the art from the following description.

### [TECHNICAL SOLUTION]

A battery testing system according to an embodiment disclosed herein includes a battery testing apparatus comprising a first connecting unit connected to a positive electrode of each of a plurality of battery cells, a second connecting unit connected to a negative electrode of each of the plurality of battery cells, a charging/discharging managing unit configured to charge or discharge the plurality of battery cells through the first connecting unit and the second connecting unit, and a monitoring unit configured to measure state information in at least any one of a charging state, a discharging state, and an idle state of each of the plurality of battery cells.

According to an embodiment, the first connecting unit may include a plurality of first terminals respectively connected to positive electrodes of the plurality of battery cells, and the second connecting unit may include a plurality of second terminals respectively connected to negative electrodes of the plurality of battery cells.

According to an embodiment, the first terminal and the second terminal may be electrically connected to the charging/discharging managing unit.

According to an embodiment, the state information may include at least one of a voltage, a temperature, electrochemical impedance spectroscopy (EIS) data, and a self-discharging current.

According to an embodiment, the monitoring unit may be further configured to transmit the measured state information of each of the plurality of battery cells to a server.

According to an embodiment, the server may be further configured to control an amount of charge of the plurality of battery cells.

According to an embodiment, the server may be further configured to generate a machine learning model that determines whether the plurality of battery cells are defective, based on state information of the plurality of battery cells, measured by the battery testing apparatus.

The battery testing system further includes a tray on which the plurality of battery cells are accommodated.

The battery testing system further includes a pressure forming unit configured to apply pressure to the plurality of battery cells.

According to an embodiment, the pressure forming unit may be provided in a space formed between the plurality of battery cells accommodated in the tray.

According to an embodiment, the pressure forming unit may be connected to a pneumatic feeder or a hydraulic feeder.

According to an embodiment, the pneumatic feeder or the hydraulic feeder may be connected to the server through a wireless or wired network.

### [ADVANTAGEOUS EFFECTS]

A battery testing apparatus and a battery testing system according to an embodiment disclosed herein may automatically perform a battery cell test to provide an accurate and continuous battery stability test.

### [DESCRIPTION OF DRAWINGS]

FIG. 1 is a block diagram illustrating a configuration of a battery testing apparatus, according to an embodiment disclosed herein.
FIG. 2 is a view for generally describing a battery testing apparatus according to an embodiment disclosed herein.
FIG. 3 is a view for describing operations of a battery testing apparatus and a server, according to an embodiment disclosed herein.
FIG. 4 is a block diagram illustrating a configuration of a battery testing system according to an embodiment disclosed herein.
FIG. 5 is a view for generally describing a battery testing system according to an embodiment disclosed herein.
FIG. 6 is a view for describing operations of a battery testing system and a pressure forming unit, according to an embodiment disclosed herein.

### [Mode for Invention]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

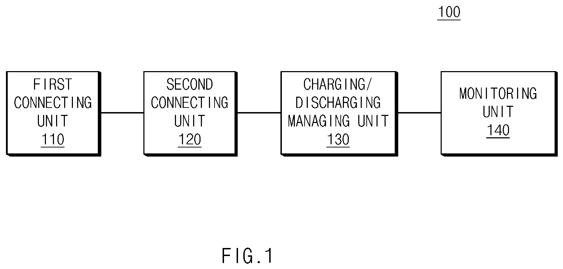

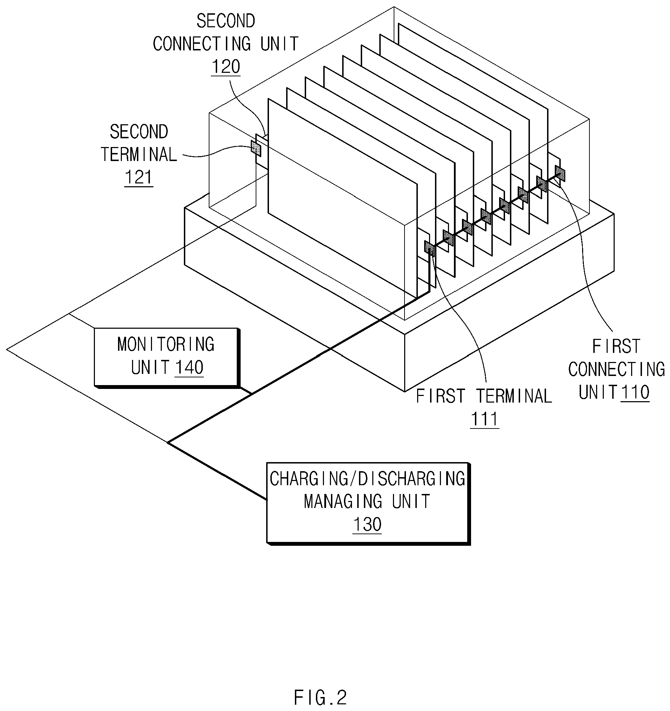

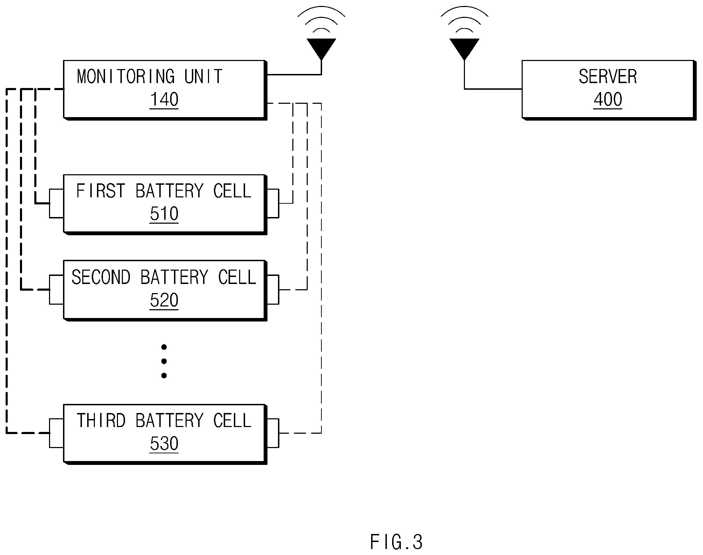

FIG. 1 is a block diagram illustrating a configuration of a battery testing apparatus, according to an embodiment disclosed herein. FIG. 2 is a view for generally describing a battery testing apparatus according to an embodiment disclosed herein. FIG. 3 is a view for describing operations of a battery testing apparatus and a server, according to an embodiment disclosed herein.

Hereinbelow, referring to FIGS. 1 and 3, a configuration and an operation of a battery testing apparatus 100 will be described.

A plurality of battery cells 510, 520, and 530 are partially illustrated in FIGS. 1 to 3, but the plurality of battery cells may include n (n is a natural number equal to or greater than 2) battery cells, without being limited thereto. The plurality of battery cells 510, 520, and 530 may be a lithium ion (Li-ion) battery, an Li-ion polymer battery, a nickel-cadmium (Ni-Cd) battery, a nickel hydrogen (Ni-MH) battery, etc., and are not limited thereto.

Referring to FIG. 1, the battery testing apparatus 100 may include a first connecting unit 110, a second connecting unit 120, a charging/discharging managing unit 130, and a monitoring unit 140.

The first connecting unit 110 may be connected to a first electrode of each of the plurality of battery cells 510, 520, and 530. For example, a first electrode may be a positive electrode. For example, the first connecting unit 110 may be implemented in the form of a gripper that holds a positive tab of each of the plurality of battery cells 510, 520, and 530.

The first connecting unit 110 may include a plurality of first terminals 111 respectively connected to the first electrodes of the plurality of battery cells 510, 520, and 530. That is, the first connecting unit 110 may be connected to the first electrode of each of the plurality of battery cells 510, 520, and 530 through the plurality of first terminals 111. Herein, the plurality of first terminals 111 may be electrically connected to the charging/discharging managing unit 130 so as to be supplied with power from the charging/discharging managing unit 130.

The second connecting unit 120 may be connected to a second electrode of each of the plurality of battery cells 510, 520, and 530. For example, a second electrode may be a negative electrode. For example, the second connecting unit 120 may be implemented in the form of a gripper that holds a negative tab of each of the plurality of battery cells 510, 520, and 530.

The second connecting unit 120 may include a plurality of second terminals 121 respectively connected to the second electrodes of the plurality of battery cells 510, 520, and 530. That is, the second connecting unit 120 may be connected to the second electrode of each of the plurality of battery cells 510, 520, and 530 through the plurality of second terminals 121. Herein, the plurality of second terminals 121 may be electrically connected to the charging/discharging managing unit 130 so as to be supplied with power from the charging/discharging managing unit 130.

The charging/discharging managing unit 130 may charge or discharge the plurality of battery cells 510, 520, and 530 through the first connecting unit 110 and the second connecting unit 120. For example, the charging/discharging managing unit 130 may be electrically connected with the first terminal 111 and the second terminal 121 to supply power to the plurality of battery cells 510, 520, and 530.

The charging/discharging managing unit 130 may manage a state of charge (SOC) value of each of the plurality of battery cells 510, 520, and 530 by charging or discharging each of the plurality of battery cells 510, 520, and 530. For example, the charging/discharging managing unit 130 may manage the amount of charge or discharge of each of the plurality of battery cells 510, 520, and 530 in response to a control command transmitted from a server 400.

The monitoring unit 140 may monitor charging, discharging, remaining battery capacity, etc., of each of the plurality of battery cells 510, 520, and 530. In this regard, the monitoring unit 140 may be understood as a battery management apparatus. More specifically, the monitoring unit 140 may measure state information of each of the plurality of battery cells 510, 520, and 530 in at least one of a charging state, a discharging state, and an idle state. Herein, the state information may include at least one of a voltage, a temperature, electrochemical impedance spectroscopy (EIS) data, and a self-discharging current.

The monitoring unit 140 may measure a voltage, a current, a temperature, etc., of each of the plurality of battery cells 510, 520, and 530, and calculate a parameter indicating a state of each of the plurality of battery cells 510, 520, and 530 based on the measured voltage, current, temperature, etc. For example, the monitoring unit 140 may measure the EIS data with respect to a change in the SOC value of each of the plurality of battery cells 510, 520, and 530.

A typical battery testing apparatus may measure required time, temperature, and voltage while repeating charging and discharging of a battery cell to evaluate whether a battery is defective. Such a battery testing method may not be able to reflect detailed characteristics of the battery. On the other hand, EIS is a battery diagnosis method using impedance measurement of the battery cell, and may detect a damaged battery cell. Impedance may be a cause that interferes with electrical conduction of an electrode when chemical reaction occurs in the battery cell. Thus, the battery testing apparatus 100 may accurately and rapidly test the battery cell based on EIS data measured by the monitoring unit 140.

Referring to FIG. 3, the monitoring unit 140 may transmit measured state information of each of the plurality of battery cells 510, 520, and 530 to the server 400 through a wired/wireless network. For example, the monitoring unit 140 may transmit the measured state information of each of the plurality of battery cells 510, 520, and 530 to the server 400 through Bluetooth, WiFi, or ZigBee.

The monitoring unit 140 may collect the state information of each of the plurality of battery cells 510, 520, and 530 and transmit the collected state information to the server 400. That is, the monitoring unit 140 may perform serial communication with each of the plurality of battery cells 510, 520, and 530 and transmit the state information of each of the plurality of battery cells 510, 520, and 530 to the server 400.

For example, the monitoring unit 140 may measure the EIS data with respect to the SOC value of each of the plurality of battery cells 510, 520, and 530 and transmit the measured EIS data to the server 400.

The server 400 may be defined as a controller that receives the state information of each of the plurality of battery cells 510, 520, and 530 and determines whether each of the plurality of battery cells 510, 520, and 530 is defective.

The server 400 may control the amount of charge of the plurality of battery cells 510, 520, and 530. More specifically, the server 400 may control the charging/discharging managing unit 130 to supply, maintain, or block power supplied to each of the plurality of battery cells 510, 520, and 530, thereby controlling the amount of charge of the plurality of battery cells 510, 520, and 530.

For example, the server 400 may control the amount of charge of the plurality of battery cells 510, 520, and 530 based on a target SOC value. Herein, the target SOC value may be defined as an SOC value in which defective battery cells are most often detected. The server 400 may control the charging/discharging managing unit 130 to control the amount of charge of the plurality of battery cells 510, 520, and 530 as the target SOC value.

More specifically, the server 400 may receive the EIS data measured through the monitoring unit 140 and analyze a change in an impedance of a battery cell to detect a defective battery cell. For example, a battery cell damaged due to discharge, a battery cell damaged due to overheat, or a battery cell damaged due to short may derive a unique impedance change graph. Thus, the server 400 may compare the EIS data measured through the monitoring unit 140 with a previously stored impedance change graph of a damaged battery cell to detect a defective battery cell.

The server 400 may be generate a machine learning model for determining whether the plurality of battery cells 510, 520, and 530 are defective, based on the state information of the plurality of battery cells 510, 520, and 530, measured by the battery testing apparatus 100. For example, the server 400 may be generate a machine learning model for detecting a defective battery cell, based on the EIS data of the plurality of battery cells 510, 520, and 530, measured by the battery testing apparatus 100.

The server 400 may determine whether the plurality of battery cells 510, 520, and 530 measured through the monitoring unit 140 are defective, by using the generated machine learning model.

As described above, the battery testing apparatus 100 according to an embodiment disclosed herein may provide a battery test for accurate and continuous detection of a defective battery cell by automatically performing a battery cell test.

Moreover, the battery testing apparatus 100 may simulate various battery test environments through the monitoring unit to simulate an actual battery manufacturing or battery module assembly processing environment.

The battery testing apparatus 100 may measure the state of the battery cell in real time to immediately determine whether the battery cell is defective. Therefore, the battery testing apparatus 100 may prevent the defective battery cell from leaking to the battery module assembly process in a battery transport process or test mid-process.

Moreover, the battery testing apparatus 100 may enable charging and discharging required for activation of the battery cell in a place where a battery is stored, without moving the battery cell with separate equipment after manufacturing of the battery cell, thereby improving the efficiency of the battery test.

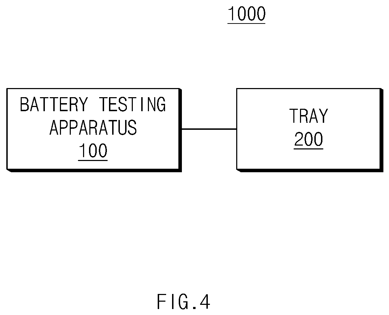

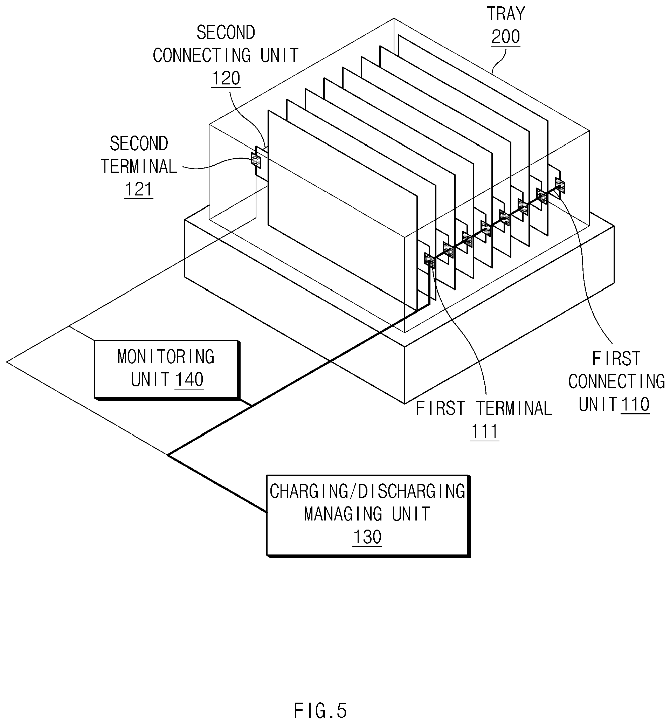

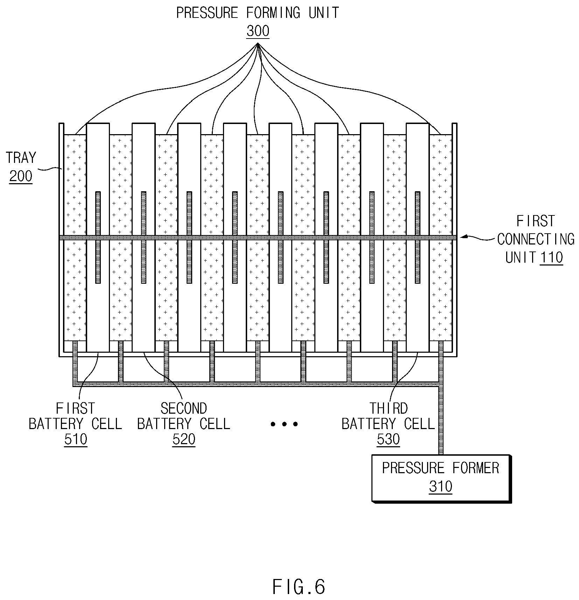

FIG. 4 is a block diagram illustrating a configuration of a battery testing system according to an embodiment disclosed herein. FIG. 5 is a view for generally describing a battery testing system according to an embodiment disclosed herein. FIG. 6 is a view for describing operations of a battery testing system and a pressure forming unit, according to an embodiment disclosed herein.

Referring to FIG. 4, a battery testing system 1000 according to an embodiment disclosed herein may include the battery testing apparatus 100 and a tray 200.

Hereinbelow, referring to FIGS. 4 and 6, a configuration and an operation of the battery testing system 1000 will be described.

Referring to FIG. 4, the battery testing system 1000 may include the battery testing apparatus 100 and the tray 200.

The battery testing apparatus 100 may be substantially the same as the battery testing apparatus 100 described with reference to FIGS. 1 to 3, and thus will be briefly described to avoid redundant description.

The battery testing apparatus 100 may include the first connecting unit 110, the second connecting unit 120, the charging/discharging managing unit 130, and the monitoring unit 140.

The first connecting unit 110 may be connected to the first electrode of each of the plurality of battery cells 510, 520, and 530. For example, the first electrode may be a positive electrode. The first connecting unit 110 may include the plurality of first terminals 111 respectively connected to the first electrodes of the plurality of battery cells 510, 520, and 530.

The second connecting unit 120 may be connected to the second electrode of each of the plurality of battery cells 510, 520, and 530. For example, the second electrode may be a negative electrode. The second connecting unit 120 may include the plurality of second terminals 121 respectively connected to the second electrodes of the plurality of battery cells 510, 520, and 530.

The charging/discharging managing unit 130 may charge or discharge the plurality of battery cells 510, 520, and 530 through the first connecting unit 110 and the second connecting unit 120.

The monitoring unit 140 may monitor charging, discharging, remaining battery capacity, etc., of each of the plurality of battery cells 510, 520, and 530. More specifically, the monitoring unit 140 may measure state information of each of the plurality of battery cells 510, 520, and 530 in at least one of a charging state, a discharging state, and an idle state.

The monitoring unit 140 may transmit the measured state information of each of the plurality of battery cells 510, 520, and 530 to the server 400 through a wired/wireless network.

The server 400 may be defined as a controller that receives the state information of each of the plurality of battery cells 510, 520, and 530 and determines whether each of the plurality of battery cells 510, 520, and 530 is defective.

The server 400 may control the amount of charge of the plurality of battery cells 510, 520, and 530.

The server 400 may be generate a machine learning model for determining whether the plurality of battery cells 510, 520, and 530 are defective, based on the state information of the plurality of battery cells 510, 520, and 530, measured by the battery testing apparatus 100.

The tray 200 may be defined as a case in which each of the plurality of battery cells 510, 520, and 530 is accommodated. The tray 200 may be loaded with the plurality of battery cells 510, 520, and 530 to provide a battery test environment in which the plurality of battery cells 510, 520, and 530 perform an auto battery test without being moved.

The plurality of battery cells 510, 520, and 530 loaded on the tray 200 may be connected in parallel such that the charging/discharging managing unit 130 may collectively control the amount of charge of the plurality of battery cells 510, 520, and 530.

The first connecting unit 110 or the second connecting unit 120 may be attached to a side of the tray 200. The tray 200 may be electrically connected to the monitoring unit 140.

The battery testing system 1000 may further include a pressure forming unit 300 that applies pressure to the plurality of battery cells 510, 520, and 530. The pressure forming unit 300 may be defined as pressure forming tool that provides pressure to the plurality of battery cells 510, 520, and 530.

The battery testing system 1000 may further include the pressure forming unit 300 that is pressure forming instrument for simulating a module assembly process to detect in advance a defect of the plurality of battery cells 510, 520, and 530, which may be expressed in a battery module assembly process.

Referring to FIG. 6, the pressure forming unit 300 may be provided in a space formed between the plurality of battery cells 510, 520, and 530 accommodated in the tray 200. More specifically, in the tray 200 where the plurality of battery cells 510, 520, and 530 are respectively accommodated, the pressure forming unit 300 may be mounted on a space between the plurality of battery cells 510, 520, and 530 to provide pressure to each of the plurality of battery cells 510, 520, and 530.

The pressure forming unit 300 may be connected to a pressure former 310 to provide pressure to each of the plurality of battery cells 510, 520, and 530. Herein, the pressure former 310 may include, for example, a pneumatic feeder or a hydraulic feeder.

Thus, for example, the pressure forming unit 300 may be connected to the pneumatic feeder to provide air pressure to the plurality of battery cells 510, 520, and 530. **In** addition, for example, the pressure forming unit 300 may be connected to the hydraulic feeder to provide air pressure to the plurality of battery cells 510, 520, and 530. Herein, the pneumatic feeder or the hydraulic feeder may be connected to the server 400 through a wired or wireless network.

Thus, the server 400 may control the pressure former 310 to provide pressure to the plurality of battery cells 510, 520, and 530.

The server 400 may control the charging/discharging managing unit 130 to repeat charging and discharging of the plurality of battery cells 510, 520, and 530 to which pressure is applied. The server 400 may control the charging/discharging managing unit 130 to set a voltage of the plurality of battery cells 510, 520, and 530 to which pressure is applied to a voltage corresponding to the target SOC value. That is, the server 400 may adjust the amount of charge of the plurality of battery cells 510, 520, and 530 to which pressure is applied to the target SOC value, thereby setting the voltage of the plurality of battery cells 510, 520, and 530 to which pressure is applied to the voltage corresponding to the target SOC value.

The server 400 may control the monitoring unit 140 to measure a self-discharge voltage or current of the plurality of battery cells 510, 520, and 530 to which pressure is applied, thereby detecting a defective battery cell.

That is, the server 400 may compare the self-discharge voltage or current of the plurality of battery cells 510, 520, and 530 to which pressure is applied with previously stored self-discharge voltage or current data of a normal battery cell to detect a defective battery cell.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present invention are intended for description rather than limitation of the present disclosure and the scope of the present invention is not limited by these embodiments. The protection scope of the present invention should be interpreted by the following claims.

## Claims

1. A battery testing system (1000) comprising:
a battery testing apparatus (100) comprising
a first connecting unit (110) configured to be of connected to a positive electrode of each of a plurality of battery cells (510, 520, 530);
a second connecting unit (120) configured to be connected to a negative electrode of each of the plurality of battery cells (510, 520, 530);
a charging/discharging managing unit (130) configured to charge or discharge the plurality of battery cells (510, 520, 530) through the first connecting unit (110) and the second connecting unit (120); and
a monitoring unit (140) configured to measure state information in at least any one of a charging state, a discharging state, and an idle state of each of the plurality of battery cells (510, 520, 530);
a tray (200) configured to accomodate the plurality of battery cells (510, 520, 530), and
a pressure forming unit (300) configured to apply pressure to the plurality of battery cells (510, 520, 530).

2. The battery testing system (1000) of claim 1, wherein
the first connecting unit (110) comprises a plurality of first terminals (111) respectively connected to positive electrodes of the plurality of battery cells (510, 520, 530), and
the second connecting unit (120) comprises a plurality of second terminals (121) respectively connected to negative electrodes of the plurality of battery cells (510, 520, 530).

3. The battery testing system (1000) of claim 2, wherein the first terminal (111) and the second terminal (121) are electrically connected to the charging/discharging managing unit (130).

4. The battery testing system (1000) of claim 1, wherein the state information comprises at least one of a voltage, a temperature, electrochemical impedance spectroscopy (EIS) data, and a self-discharging current.

5. The battery testing system (1000) of claim 1, wherein the monitoring unit (140) is further configured to transmit the measured state information of each of the plurality of battery cells (510, 520, 530) to a server (400).

6. The battery testing system (1000) of claim 5, wherein the server (400) is further configured to control an amount of charge of the plurality of battery cells (510, 520, 530).

7. The battery testing system (1000) of claim 5, wherein the server (400) is further configured to generate a machine learning model that determines whether the plurality of battery cells (510, 520, 530) are defective, based on state information of the plurality of battery cells (510, 520, 530), measured by the battery testing apparatus (100).

8. The battery testing system (1000) of claim 1, wherein the pressure forming unit (300) is provided in a space formed between the plurality of battery cells (510, 520, 530) accommodated in the tray (200).

9. The battery testing system (1000) of claim 1, wherein the pressure forming unit (300) is connected to a pneumatic feeder (311) or a hydraulic feeder (312).

10. The battery testing system (1000) of claim 9, wherein the pneumatic feeder (311) or the hydraulic feeder (312) is connected to the server (400) through a wireless or wired network.

## Patentansprüche

1. Batterieprüfsystem (1000) aufweisend:
eine Batterieprüfvorrichtung (100) aufweisend
eine erste Verbindungseinheit (110), die konfiguriert ist, um mit einer positiven Elektrode von jeder von mehreren Batteriezellen (510, 520, 530) verbunden zu werden;
eine zweite Verbindungseinheit (120), die konfiguriert ist, um mit einer negativen Elektrode von jeder der mehreren Batteriezellen (510, 520, 530) verbunden zu werden;
eine Lade-/Entladeverwaltungseinheit (130), die konfiguriert ist, um die mehreren Batteriezellen (510, 520, 530) durch die erste Verbindungseinheit (110) und die zweite Verbindungseinheit (120) zu laden oder zu entladen; und
eine Überwachungseinheit (140), die konfiguriert ist, um Zustandsinformationen in mindestens einem von einem Ladezustand, einem Entladezustand und einem Ruhezustand von jeder der mehreren Batteriezellen (510, 520, 530) zu messen;
einen Träger (200), der konfiguriert ist, die mehreren Batteriezellen (510, 520, 530) aufzunehmen, und
eine Druckerzeugungseinheit (300), die konfiguriert ist, Druck auf die mehreren Batteriezellen (510, 520, 530) auszuüben.

2. Batterieprüfsystem (1000) nach Anspruch 1, wobei
die erste Verbindungseinheit (110) mehrere erste Anschlüsse (111) aufweist, die jeweils mit positiven Elektroden der mehreren Batteriezellen (510, 520, 530) verbunden sind, und
die zweite Verbindungseinheit (120) mehrere zweite Anschlüsse (121) aufweist, die jeweils mit negativen Elektroden der mehreren Batteriezellen (510, 520, 530) verbunden sind.

3. Batterieprüfsystem (1000) nach Anspruch 2, wobei der erste Anschluss (111) und der zweite Anschluss (121) elektrisch mit der Lade-/Entladeverwaltungseinheit (130) verbunden sind.

4. Batterieprüfsystem (1000) nach Anspruch 1, wobei die Zustandsinformationen eine Spannung und/oder eine Temperatur und/oder elektrochemische Impedanzspektroskopie-Daten, EIS-Daten, und/oder einen Selbstentladestrom aufweisen.

5. Batterieprüfsystem (1000) nach Anspruch 1, wobei die Überwachungseinheit (140) ferner konfiguriert ist, die gemessenen Zustandsinformationen von jeder der mehreren Batteriezellen (510, 520, 530) an einen Server (400) zu übertragen.

6. Batterieprüfsystem (1000) nach Anspruch 5, wobei der Server (400) ferner konfiguriert ist, eine Ladungsmenge der mehreren Batteriezellen (510, 520, 530) zu steuern.

7. Batterieprüfsystem (1000) nach Anspruch 5, wobei der Server (400) ferner konfiguriert ist, ein Maschinenlernmodell zu erzeugen, das basierend auf Zustandsinformationen der mehreren Batteriezellen (510, 520, 530), die durch die Batterieprüfvorrichtung (100) gemessen werden, bestimmt, ob die mehreren Batteriezellen (510, 520, 530) defekt sind.

8. Batterieprüfsystem (1000) nach Anspruch 1, wobei die Druckerzeugungseinheit (300) in einem Raum vorgesehen ist, der zwischen den mehreren Batteriezellen (510, 520, 530) gebildet ist, die in dem Träger (200) aufgenommen sind.

9. Batterieprüfsystem (1000) nach Anspruch 1, wobei die Druckerzeugungseinheit (300) mit einer pneumatischen Zuführeinrichtung (311) oder einer hydraulischen Zuführeinrichtung (312) verbunden ist.

10. Batterieprüfsystem (1000) nach Anspruch 9, wobei die pneumatische Zuführeinrichtung (311) oder die hydraulische Zuführeinrichtung (312) mit dem Server (400) über ein drahtloses oder drahtgebundenes Netzwerk verbunden ist.

## Revendications

1. Système de test de batterie (1000) comprenant :
un appareil de test de batterie (100) comprenant
une première unité de connexion (110) configurée pour être connectée à une électrode positive de chaque cellule d'une pluralité de cellules de batterie (510, 520, 530) ;
une deuxième unité de connexion (120) configurée pour être connectée à une électrode négative de chaque cellule de la pluralité de cellules de batterie (510, 520, 530) ;
une unité de gestion de charge/décharge (130) configurée pour charger ou décharger la pluralité de cellules de batterie (510, 520, 530) par l'intermédiaire de la première unité de connexion (110) et de la deuxième unité de connexion (120) ; et
une unité de surveillance (140) configurée pour mesurer des informations d'état dans au moins un état quelconque parmi un état de charge, un état de décharge, et un état inactif de chaque cellule de la pluralité de cellules de batterie (510, 520, 530) ;
un plateau (200) configuré pour recevoir la pluralité de cellules de batterie (510, 520, 530), et
une unité de formation de pression (300) configurée pour appliquer une pression à la pluralité de cellules de batterie (510, 520, 530).

2. Système de test de batterie (1000) de la revendication 1, dans lequel
la première unité de connexion (110) comprend une pluralité de premières bornes (111) connectées respectivement à des électrodes positives de la pluralité de cellules de batterie (510, 520, 530), et
la deuxième unité de connexion (120) comprend une pluralité de deuxièmes bornes (121) connectées respectivement à des électrodes négatives de la pluralité de cellules de batterie (510, 520, 530).

3. Système de test de batterie (1000) de la revendication 2, dans lequel la première borne (111) et la deuxième borne (121) sont connectées électriquement à l'unité de gestion de charge/décharge (130).

4. Système de test de batterie (1000) de la revendication 1, dans lequel les informations d'état comprennent au moins un élément parmi une tension, une température, des données de spectroscopie d'impédance électrochimique (EIS), et un courant d'auto-décharge.

5. Système de test de batterie (1000) de la revendication 1, dans lequel l'unité de surveillance (140) est configurée en outre pour transmettre les informations d'état mesurées de chaque cellule de la pluralité de cellules de batterie (510, 520, 530) à un serveur (400).

6. Système de test de batterie (1000) de la revendication 5, dans lequel le serveur (400) est configuré en outre pour contrôler une quantité de charge de la pluralité de cellules de batterie (510, 520, 530).

7. Système de test de batterie (1000) de la revendication 5, dans lequel le serveur (400) est configuré en outre pour générer un modèle à apprentissage machine qui détermine si la pluralité de cellules de batterie (510, 520, 530) sont défectueuses, sur la base des informations d'état de la pluralité de cellules de batterie (510, 520, 530), mesurées par l'appareil de test de batterie (100).

8. Système de test de batterie (1000) de la revendication 1, dans lequel l'unité de formation de pression (300) est prévue dans un espace formé entre la pluralité de cellules de batterie (510, 520, 530) reçues dans le plateau (200).

9. Système de test de batterie (1000) de la revendication 1, dans lequel l'unité de formation de pression (300) est connectée à un alimentateur pneumatique (311) ou à un alimentateur hydraulique (312).

10. Système de test de batterie (1000) de la revendication 9, dans lequel l'alimentateur pneumatique (311) ou l'alimentateur hydraulique (312) est connecté au serveur (400) par l'intermédiaire d'un réseau sans fil ou câblé.
